# FASCICULE DE BREVET EUROPEEN

(11) **EP 2 537 797 B1**
(45) Date de publication et mention de la délivrance du brevet: **15.06.2016**
(21) Numéro de dépôt: 12172748.1
(22) Date de dépôt: 20.06.2012
(51) Int. Cl.: B81B 7/00

(54) **Structure à matériau getter protégée hermétiquement lors de sa réalisation**
Gettermaterial-Struktur, die bei ihrer Herstellung hermetisch geschützt ist
Structure with getter material hermetically protected during the manufacturing thereof

(30) Priorité: 23.06.2011 FR 1155564
(43) Date de publication de la demande: 26.12.2012
(73) Titulaire: Commissariat à l'Énergie Atomique et aux Énergies Alternatives, 75015 Paris (FR)
(72) Inventeur: Caplet, Stéphane, 111 Tapei City (CN); Baillin, Xavier, 38920 Crolles (FR)
(74) Mandataire: Ilgart, Jean-Christophe

(56) Documents cités:
- WO-A1-2009/041950
- US-A1- 2006 137 460
- CAPLET S ET AL: "Vacuum wafer-level packaging for MEMS applications", PROCEEDINGS OF SPIE, SPIE, US, vol. 4979, 27 janvier 2003 (2003-01-27), pages 271-278, XP002360340, ISSN: 0277-786X, DOI: 10.1117/12.478249

## Description

### DOMAINE TECHNIQUE

L'invention concerne le domaine des structures getter, c'est-à-dire des structures comprenant un ou plusieurs matériaux getter pour réaliser une absorption et/ou une adsorption gazeuse dans un environnement clos. Une telle structure peut notamment être utilisée dans le domaine des microcomposants tels que les microsystèmes électromécaniques (MEMS) ou nanosystèmes électromécaniques (NEMS), par exemple des accéléromètres, des gyromètres, ou tout autre dispositif par exemple destiné à être encapsulé dans un environnement sous vide poussé, sous pression contrôlée, ou encore sous atmosphère protectrice.

### ÉTAT DE LA TECHNIQUE ANTÉRIEURE

Un matériau getter est un matériau comportant, de façon intrinsèque et/ou de par sa morphologie microscopique, des propriétés d'absorption et/ou d'adsorption gazeuse. Un tel matériau getter peut ainsi former une pompe de gaz chimique lorsque celui-ci est disposé dans un environnement clos. Ce type de matériau peut également être utilisé dans de nombreuses applications microélectroniques telles que les tubes à vide, les systèmes à effet de champ ou encore avec des microcomposants tels que les MEMS ou NEMS pour réaliser par exemple un environnement sous vide poussé ou sous pression contrôlée. Dans le cas des MEMS ou NEMS encapsulés, un environnement sous vide poussé formé autour du dispositif permet par exemple d'obtenir un meilleur fonctionnement des systèmes mécaniques résonnants mais aussi des systèmes optiques sensibles à l'absorption du rayonnement lumineux par des gaz environnants du dispositif.

Des matériaux getter non évaporables (appelés NEG) sont par exemple des métaux tels que du titane, du zirconium, de l'hafnium, ou encore des alliages métalliques binaires de ces trois métaux. Un tel matériau getter non évaporable est généralement déposé directement sur une paroi de l'enceinte dans laquelle on cherche à réaliser une pompe chimique sous la forme d'une couche mince. Ce matériau est ensuite activé thermiquement en le chauffant à travers la paroi de l'enceinte sur laquelle il est déposé.

Le document US 6 923 625 B2 décrit la réalisation d'une telle couche mince de matériau getter. Après avoir formé le matériau getter, celui-ci est protégé par une fine couche de protection, par exemple composée de métal, permettant d'empêcher une contamination ou une oxydation du matériau getter, et également d'empêcher que le matériau getter réalise une absorption gazeuse avant qu'il soit encapsulé. La couche de protection est ensuite supprimée afin d'exposer le matériau getter aux gaz environnants.

Le document FR 2 883 099 décrit la réalisation d'un matériau getter protégé par une couche de protection et utilisé pour une encapsulation d'un microcomposant. Une fois l'encapsulation du microcomposant et du matériau getter réalisée, la couche de protection est consommée afin d'exposer le matériau getter à l'atmosphère de la cavité.

Dans ces deux documents, la couche de protection du matériau getter est supprimée grâce à un traitement thermique entraînant la diffusion ou le fluage de la couche de protection, exposant ainsi le matériau getter dans la cavité. Or, ce traitement thermique peut être gênant voir incompatible avec le reste de la structure encapsulée compte tenu des budgets thermiques mis en jeu.

### EXPOSÉ DE L'INVENTION

Un but de la présente invention est de proposer une nouvelle structure getter pouvant être utilisée pour réaliser une absorption et/ou une adsorption gazeuse par exemple dans une cavité fermée hermétiquement, dans laquelle le matériau getter est protégé hermétiquement lors de sa réalisation, et ne nécessitant pas la mise en oeuvre d'un traitement thermique pour exposer le matériau getter aux gaz environnants.

Il est ainsi proposé une structure getter comportant au moins une portion de matériau getter perméable aux gaz recouverte par au moins une couche de protection hermétique aux gaz, et dans laquelle au moins une ouverture localisée traverse la couche de protection et forme un accès à la portion de matériau getter perméable aux gaz.

La présente invention propose un procédé de réalisation d'un dispositif comportant au moins les étapes de :
- réalisation d'une structure getter comportant au moins une portion de matériau getter perméable aux gaz recouverte par au moins une couche de protection hermétique aux gaz ;
- encapsulation hermétique de la structure getter dans une cavité ;
- réalisation d'au moins une ouverture localisée traversant la couche de protection et formant un accès à la portion de matériau getter perméable aux gaz.

Ainsi, en réalisant une ouverture localisée à travers la couche de protection, c'est-à-dire une ouverture réalisée à travers une partie seulement de la couche de protection hermétique et telle qu'une ou plusieurs portions restantes de la couche de protection hermétique recouvre la portion de matériau getter perméable aux gaz, il n'est pas nécessaire de supprimer totalement la couche de protection hermétique aux gaz lorsque l'on réalise une encapsulation de la structure getter. De plus, une telle ouverture localisée est réalisée sans mettre en oeuvre un traitement thermique pouvant endommager le reste de la structure.

On entend par « perméabilité » d'une portion de matériau son aptitude à permettre la circulation de gaz dans ladite portion de matériau, aussi bien dans au moins une direction parallèle à un plan principal de la portion que dans une direction perpendiculaire à ce plan. La portion de matériau getter est ici perméable aux gaz, c'est-à-dire que des gaz peuvent circuler à travers cette portion, aussi bien latéralement que verticalement.

La portion de matériau getter perméable aux gaz peut être disposée contre un support, des portions de la couche de protection pouvant reposer sur le support. Dans ce cas, la portion de matériau getter perméable aux gaz est encapsulée entre le support et la couche de protection.

Une première partie de la couche de protection peut être disposée contre un support, la portion de matériau getter perméable aux gaz pouvant être disposée au-dessus de, ou sur, cette première partie de la couche de protection, une seconde partie de la couche de protection pouvant recouvrir la portion de matériau getter perméable aux gaz et reposer sur la première partie de la couche de protection. Dans ce cas, la portion de matériau getter perméable aux gaz est entièrement encapsulée par la couche de protection.

L'ensemble formé par la portion de matériau getter perméable aux gaz et la couche de protection qui encapsule le matériau getter peut être formé directement sur le support ou bien être rapporté sur celui-ci après avoir été réalisé.

La portion de matériau getter perméable aux gaz peut être disposée contre au moins une autre portion de matériau getter distincte de la portion de matériau getter perméable aux gaz telle que ladite autre portion de matériau getter soit apte à réaliser une absorption et/ou une adsorption gazeuse à travers au moins la portion de matériau getter perméable aux gaz.

La portion de matériau getter perméable aux gaz peut entourer tout ou partie de ladite autre portion de matériau getter.

La portion de matériau getter perméable aux gaz peut comporter un ou plusieurs canaux réalisés dans, ou à travers, ladite portion de matériau getter perméable aux gaz. Dans ce cas, des gaz peuvent circuler dans tout ou partie de la portion de matériau getter à travers ces canaux.

La portion de matériau getter perméable aux gaz peut être composée d'au moins un matériau poreux. Dans ce cas, le matériau getter comporte des porosités, ou pores, latérales et verticales permettant aux gaz de circuler dans toute la portion de matériau getter à travers ces porosités.

Les porosités du matériau getter poreux sont par exemple ouvertes et de dimensions comprises entre environ quelques nanomètres et quelques centaines de nanomètres, par exemple comprises entre environ 2 nm et 900 nm. Les dimensions des porosités du matériau getter poreux peuvent influer sur la vitesse de l'accessibilité des gaz au matériau getter.

La couche de protection peut avoir une épaisseur supérieure à environ 100 nm.

La structure getter peut comporter un empilement de plusieurs portions de matériau getter perméables aux gaz et de plusieurs autres portions de matériau getter, au moins une face de chacune desdites autres portions de matériau getter pouvant être disposée contre au moins une des portions de matériau getter perméables aux gaz telle que chacune desdites autres portions de matériau getter soit apte à réaliser une absorption et/ou une adsorption gazeuse par ladite face à travers ladite au moins une des portions de matériau getter perméables aux gaz, la couche de protection pouvant recouvrir ledit empilement.

La couche de protection peut encapsuler entièrement la ou les portions de matériau getter perméables aux gaz et, lorsque la structure getter comporte au moins une autre portion de matériau getter, la couche de protection peut encapsuler entièrement ladite ou lesdites autres portions de matériau getter, l'ouverture localisée pouvant former un accès au moins à la ou aux portions de matériau getter perméables aux gaz. Lorsque la structure getter comporte ladite ou lesdites autres portions de matériau getter, l'ouverture localisée peut former en outre un accès à ladite ou auxdites autres portions de matériau getter, éventuellement à travers les portions de matériau getter perméables.

L'invention concerne également un dispositif comportant au moins une cavité dans laquelle est encapsulée hermétiquement au moins une structure getter telle que décrite ci-dessus. Dans un tel dispositif, l'ouverture localisée est réalisée avantageusement après l'encapsulation de la structure getter dans la cavité.

La cavité peut être formée entre un substrat et un capot, la structure getter pouvant être solidaire du substrat et/ou du capot.

Le dispositif peut comporter en outre au moins un microcomposant encapsulé hermétiquement dans la cavité.

Il est également décrit un procédé de réalisation d'une structure getter, comportant au moins les étapes de :
- réalisation d'au moins une portion de matériau getter perméable aux gaz ;
- réalisation d'au moins une couche de protection hermétique aux gaz recouvrant la portion de matériau getter perméable aux gaz ;
- réalisation d'au moins une ouverture localisée à travers la couche de protection hermétique, formant un accès à la portion de matériau getter perméable aux gaz.

L'ouverture localisée peut être réalisée par au moins une fusion localisée de la couche de protection (par exemple un impact laser localisé sur la couche de protection ou une fusion eutectique de la couche de protection avec un matériau fusible reporté localement sur cette couche à l'endroit où l'ouverture doit être réalisée) et/ou en cassant une partie de la structure getter.

La portion de matériau getter perméable aux gaz peut être réalisée par au moins un dépôt de matériau getter sur un support, la couche de protection pouvant être déposée sur la portion de matériau getter perméable aux gaz et sur une partie du support.

Le procédé peut comporter en outre, avant la réalisation de la portion de matériau getter perméable aux gaz, la réalisation d'une première partie de la couche de protection contre un support, la portion de matériau getter perméable aux gaz pouvant être réalisée ensuite sur cette première partie de la couche de protection, et peut comporter en outre la réalisation d'une seconde partie de la couche de protection recouvrant la portion de matériau getter perméable aux gaz et reposant sur la première partie de la couche de protection.

Le procédé peut comporter en outre, entre l'étape de réalisation de la portion de matériau getter perméable aux gaz et l'étape de réalisation de la couche de protection, une étape de réalisation d'au moins une autre portion de matériau getter distincte de la portion de matériau getter perméable aux gaz et disposée contre la portion de matériau getter perméable aux gaz telle que ladite autre portion de matériau getter soit apte à réaliser une absorption et/ou une adsorption gazeuse à travers au moins la portion de matériau getter perméable aux gaz, la couche de protection pouvant recouvrir ladite autre portion de matériau getter.

Le procédé peut comporter en outre, avant l'étape de réalisation de la portion de matériau getter perméable aux gaz, une étape de réalisation d'au moins une autre portion de matériau getter distincte de la portion de matériau getter perméable aux gaz, la portion de matériau getter perméable aux gaz pouvant être réalisée sur ladite autre portion de matériau getter telle que ladite autre portion de matériau getter soit apte à réaliser une absorption et/ou une adsorption gazeuse à travers au moins la portion de matériau getter perméable aux gaz, la couche de protection pouvant recouvrir ladite portion de matériau getter perméable aux gaz.

La portion de matériau perméable aux gaz peut être réalisée telle qu'elle entoure, ou déborde de, tout ou partie de ladite autre portion de matériau getter.

Le procédé peut comporter la réalisation d'un empilement de plusieurs portions de matériau getter perméables aux gaz et de plusieurs autres portions de matériau getter tel qu'au moins une face de chacune desdites autres portions de matériau getter soit disposée contre au moins une des portions de matériau getter perméables aux gaz, chacune desdites autres portions de matériau getter pouvant être apte à réaliser une absorption et/ou une adsorption gazeuse par ladite face à travers ladite au moins une des portions de matériau getter perméables aux gaz, la couche de protection pouvant recouvrir ledit empilement.

La couche de protection peut encapsuler entièrement la ou les portions de matériau getter perméables aux gaz et, lorsque la structure getter comporte au moins une autre portion de matériau getter, la couche de protection peut encapsuler entièrement ladite ou lesdites autres portions de matériau getter, l'ouverture localisée pouvant former un accès au moins à la ou aux portions de matériau getter perméables aux gaz. Lorsque la structure getter comporte ladite ou lesdites autres portions de matériau getter, l'ouverture localisée peut former en outre un accès à ladite ou auxdites portions de matériau getter.

L'invention concerne également un procédé de réalisation d'un dispositif comportant au moins les étapes de :
- réalisation d'une structure getter telle que décrite ci-dessus ;
- encapsulation hermétique de la structure getter dans une cavité ;
dans lequel l'ouverture localisée de la structure getter est réalisée après l'encapsulation hermétique de la structure getter dans la cavité.

La cavité peut être formée en solidarisant un substrat à un capot, la structure getter pouvant être solidaire du substrat et/ou du capot.

Le procédé peut comporter en outre la réalisation d'un microcomposant et l'encapsulation hermétique du microcomposant dans la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent les étapes d'un procédé de réalisation d'un dispositif, objet de la présente invention, dans lequel un procédé de réalisation d'une structure getter est mis en oeuvre selon un premier mode de réalisation ;
- les figures 2A à 2C représentent des structures getter, objets de la présente invention, selon d'autres modes de réalisation ;
- la figure 3 représente une vue de dessus schématique d'un matériau getter poreux d'une structure getter, objet de la présente invention ;
- la figure 4 représente une vue de dessus schématique d'un matériau getter comportant des canaux ;
- les figures 5A à 5C représentent les étapes d'un procédé de réalisation d'un dispositif dans lequel un procédé de réalisation d'une structure getter, objet de la présente invention, est mis en oeuvre selon un quatrième mode de réalisation ;
- les figures 6A à 6C représentent les étapes d'un procédé de réalisation d'un dispositif dans lequel un procédé de réalisation d'une structure getter, objet de la présente invention, est mis en oeuvre selon un cinquième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

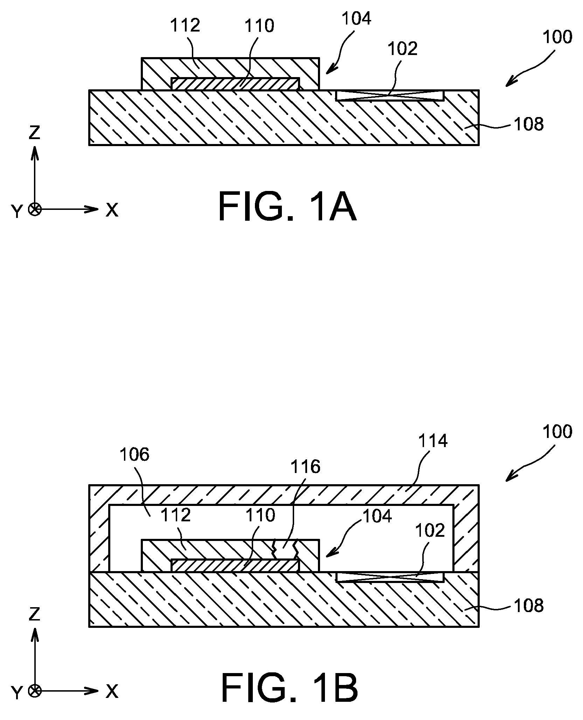

On se réfère aux figures 1A et 1B qui représentent les étapes de réalisation d'un dispositif 100 selon un premier mode de réalisation, comportant un microcomposant 102 destiné à être encapsulé, avec une structure getter 104, dans une cavité 106.

Le dispositif 100 comporte le microcomposant 102 réalisé sur un support, ici un substrat 108, par exemple formé d'une couche de matériau semi-conducteur. La structure getter 104 est également réalisée sur le substrat 108, à côté du microcomposant 102. Sur la figure 1A, la structure getter 104 comporte une portion de matériau getter perméable aux gaz 110 formée sur le substrat 108 et une couche de protection 112, hermétique aux gaz et recouvrant complètement la portion de matériau getter perméable aux gaz 110. La portion de matériau getter perméable aux gaz 110 et la couche de protection hermétique 112 sont par exemple formées par des dépôts successifs avantageusement réalisés dans un même cycle de vide ou sous une même atmosphère. On entend par « même cycle de vide » le fait que l'on ne remet pas la structure à l'air libre. On peut éventuellement, dans un même cycle de vide, remettre la structure sous atmosphère neutre notamment pour le transfert d'un équipement à un autre, par exemple d'une chambre de dépôt à une autre, afin d'éviter de saturer le matériau getter déposé.

Le matériau getter de la portion 110 est un matériau getter non évaporable, par exemple du titane et/ou du zirconium et/ou du chrome et/ou du vanadium et/ou du niobium et/ou du tantale et/ou tout autre alliage ou matériau présentant des propriétés d'absorption et/ou adsorption gazeuse. La portion de matériau getter perméable aux gaz 110 a une épaisseur par exemple comprise entre environ 50 nm et 10 µm. La portion de matériau getter perméable aux gaz 110 pourra également être réalisée sous la forme d'une couche mince.

La couche de protection hermétique 112 est par exemple composée d'or et/ou d'aluminium, et a par exemple une épaisseur comprise entre environ 100 nm et plusieurs micromètres ou plusieurs dizaines de micromètres, la limite supérieure de cette épaisseur étant liée uniquement à l'encombrement maximal souhaité au sein du dispositif 100. La couche de protection hermétique 112 protège ainsi la portion de matériau getter perméable aux gaz 110 lors de la mise en oeuvre d'étapes pouvant par exemple détériorer le matériau getter et/ou altérer les propriétés d'absorption et/ou d'adsorption gazeuse du matériau getter, par exemple dans le cas d'un nettoyage chimique par solution HF. Cette couche de protection 112 permet également d'empêcher temporairement le matériau getter 110 de réaliser un pompage gazeux (du fait que le matériau getter 110 est destiné à réaliser ce pompage gazeux qu'après avoir été disposé dans la cavité qui sera fermée hermétiquement). Dans ce premier mode de réalisation, la protection hermétique du matériau getter perméable aux gaz 110 est également assurée en partie par le substrat 108 contre lequel la portion de matériau getter perméable aux gaz 110 est disposée.

Le matériau getter peut être tout d'abord déposé sous la forme d'une couche, par exemple par évaporation ou par pulvérisation, sur le substrat 108, puis structuré (par exemple par gravure) afin de former la portion 110 aux dimensions souhaitées, ou bien être réalisé directement par un dépôt du matériau getter à travers un pochoir.

Comme représenté sur la figure 1B, on réalise ensuite un scellement hermétique d'un capot 114 sur le substrat 108 afin d'encapsuler la structure getter 104 et le microcomposant 102 dans la même cavité 106. Le capot 114 est par exemple composé de verre.

Ainsi, le matériau getter de la structure 104 est protégé hermétiquement lors du scellement hermétique du capot 114 sur le substrat 108 par la couche de protection 112. La température à laquelle est réalisé ce scellement hermétique du capot 114 peut entrainer l'activation thermique de la portion de matériau getter perméable aux gaz 110. La couche de protection hermétique 112 permet donc d'éviter au matériau getter de réaliser une absorption et/ou une adsorption gazeuse lors de ce scellement.

Lorsque l'on souhaite « activer » la fonction d'absorption et/ou d'adsorption gazeuse du matériau getter 110, après que le capot 114 soit scellé au substrat 108, on réalise alors une ouverture localisée 116 à travers la couche de protection hermétique 112, par exemple par impact laser à travers le capot 114. Le capot 114 est ici transparent (par exemple composé de verre) vis-à-vis du laser utilisé pour exposer localement le matériau getter 110 à travers l'ouverture 116, ce qui permet au laser de traverser le capot 114 et réaliser l'ouverture locale 116 par impact du laser sur le matériau de la couche de protection hermétique 112. L'ouverture 116 débouche sur la surface de la portion de matériau getter perméable aux gaz 110. La couche de protection hermétique 112 n'est donc pas complètement éliminée lorsque le matériau getter rempli sa fonction de pompage gazeux en étant exposé à l'atmosphère ambiante.

Bien que l'ouverture 116 soit localisée, c'est-à-dire ne révélant qu'une partie de la portion de matériau getter perméable aux gaz 110, l'absorption et/ou l'adsorption gazeuse est réalisée par l'ensemble de la portion de matériau getter 110 grâce à la perméabilité aux gaz présentée par la portion 110.

La perméabilité aux gaz de la portion de matériau getter 110 peut être obtenue du fait que le matériau getter de la portion 110 comporte des porosités ouvertes afin que du gaz puisse circuler à travers celles-ci. Dans ce cas, la portion de matériau getter 110 présente, en son sein, des porosités latérales (porosités présentant des ouvertures au niveau de ses faces latérales) et verticales (présentant des ouvertures au niveau de ses faces avant et arrière), ces différentes porosités communiquant entre elles au sein de la portion 110. Ainsi, du gaz peut circuler à travers les porosités de la portion 110.

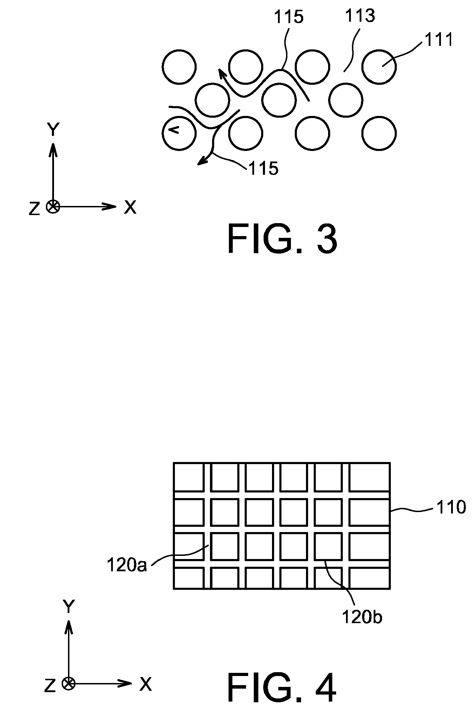

Un tel matériau getter poreux comporte des porosités verticales et latérales formées entre les grains du matériau getter, permettant la circulation d'un gaz au sein de la portion 110. Il est donc possible de réaliser une ouverture 116 de dimensions réduites. Un tel matériau getter poreux peut être obtenu par un dépôt réalisé à une température de dépôt Ts telle que le rapport Ts/Tm soit inférieur à environ 0,3, Tm étant la température de fusion du matériau getter, les températures Ts et Tm étant exprimées en Kelvin. Lorsque le matériau getter poreux est déposé par évaporation dans ces conditions de dépôt, le matériau getter poreux obtenu présente alors une structure colonnaire comprenant des cônes inversés (partie la plus large du cône en haut), en forme de dômes dans la partie supérieure, ces cônes étant séparés par des espaces vides. La figure 3 représente une vue de dessus schématique d'un matériau getter poreux. On voit sur cette figure 3 que des espaces 113 entre des grains colonnaires 111 de matériau getter permettent une circulation des gaz au sein du matériau getter, cette circulation étant représentée par des flèches 115. L'ouvrage « Materials Science of Thin Films », Second Edition, Milton Ohring, Academic Press, chapitre 9.2.1.2 SZM for Evaporated Films, page 498, décrit des détails de réalisation d'un tel matériau poreux.

La perméabilité aux gaz de la portion de matériau getter 110 peut également être obtenue en structurant la portion de matériau getter 110 afin de former à travers celle-ci des canaux, ou micro-canaux, permettant à des gaz de circuler à travers le matériau getter. Ces canaux, obtenus par exemple par la mise en oeuvre d'étapes de photolithographie et de gravure, peuvent traverser la portion de matériau getter 110 sur toute son épaisseur (cette épaisseur étant par exemple comprise entre environ 1 µm et 10 µm), depuis une face avant de la portion de matériau getter 110 se trouvant du côté de l'ouverture localisée 116 jusqu'à une face arrière de la portion de matériau getter 110 se trouvant du côté du substrat 108. Les canaux sont réalisés à travers la portion de matériau getter 110 avant que celle-ci ne soit recouverte par la couche de protection hermétique 112.

La figure 4 représente une vue de dessus schématique de la portion de matériau getter 110 comportant de tels canaux 120. On voit sur cette figure que la fonction de perméabilité est obtenue grâce à des canaux 120, par exemple disposés sous la forme d'un quadrillage composé de canaux verticaux 120a et de canaux horizontaux 120b, perpendiculaires les uns par rapport aux autres. Ainsi, un gaz peut entrer, depuis la face avant de la portion de matériau getter 110, par les parties des canaux 120 se trouvant au niveau de la ou des ouvertures 116 réalisées à travers la couche de protection hermétique 112 et se diffuser dans toute la portion de matériau getter 110 en circulant, aussi bien verticalement que latéralement, à travers les canaux 120. La largeur des canaux est par exemple comprise entre environ 100 nm et 1 µm. Les canaux 120 sont réalisés de préférence tels qu'ils présentent un rapport de forme (hauteur / largeur) supérieur ou égal à 2. Sur l'exemple de la figure 4, les canaux 120 débouchent au niveau des faces latérales de la portion de matériau getter 110. Toutefois, dans une variante, il est possible que les canaux 120 ne soient pas débouchant latéralement.

Le motif formé par les canaux 120 peut être différent de celui représenté sur la figure 4, et peut ne pas former un quadrillage. Ainsi, les canaux 120 peuvent former par exemple une étoile, ou n'importe quel autre motif.

Il est possible de réaliser plusieurs ouvertures locales 116 à travers la couche de protection hermétique 112, ces ouvertures formant différents accès au matériau getter 110. La ou les ouvertures 116 peuvent avoir une forme quelconque, par exemple cylindrique, et présenter une dimension (par exemple un diamètre dans le cas d'ouvertures de formes cylindriques), dans le plan (X,Y), comprise entre environ 1 et 10 µm.

Si la portion de matériau getter 110 et la couche de protection hermétique 112 n'ont pas été réalisées dans le même cycle de vide, le matériau getter peut être activé thermiquement lors de son encapsulation hermétique. Cette activation thermique permet de régénérer le potentiel de capacité de pompage du matériau getter. On régénère de préférence le potentiel de capacité de pompage du getter avant de réaliser une ouverture locale dans la couche de protection hermétique. Ainsi, on obtient un matériau getter avec tout son potentiel actif encapsulé hermétiquement.

Cette encapsulation de protection par la couche 112 permet d'une part de maintenir ce potentiel de capacité de pompage actif jusqu'à la mise en place du getter dans le dispositif et la réalisation de l'ouverture locale 116 dans la couche de protection hermétique 112, formant un canal d'accès au matériau getter. D'autre part, l'encapsulation peut aussi jouer un rôle de protection contre les éventuelles agressions du process qu'il reste à réaliser jusqu'au produit final : par exemple lors d'un nettoyage chimique incompatible avec le matériau getter (par exemple avec une solution HF), ou lors d'un traitement thermique sous atmosphère pompable par le getter, par exemple à une température d'environ 400°C sous atmosphère de N₂.

Le matériau getter étant encapsulé hermétiquement, il est possible de réaliser un dégazage du capot à des températures telles qu'un getter non hermétiquement protégé s'activerait et réaliserait un pompage gazeux (dans l'enceinte de la chambre de dégazage ou lors de la remise à l'air). Du fait que le matériau getter soit encapsulé hermétiquement, le dégazage du capot et la remise à l'air ne dégrade pas la capacité de pompage potentielle du getter.

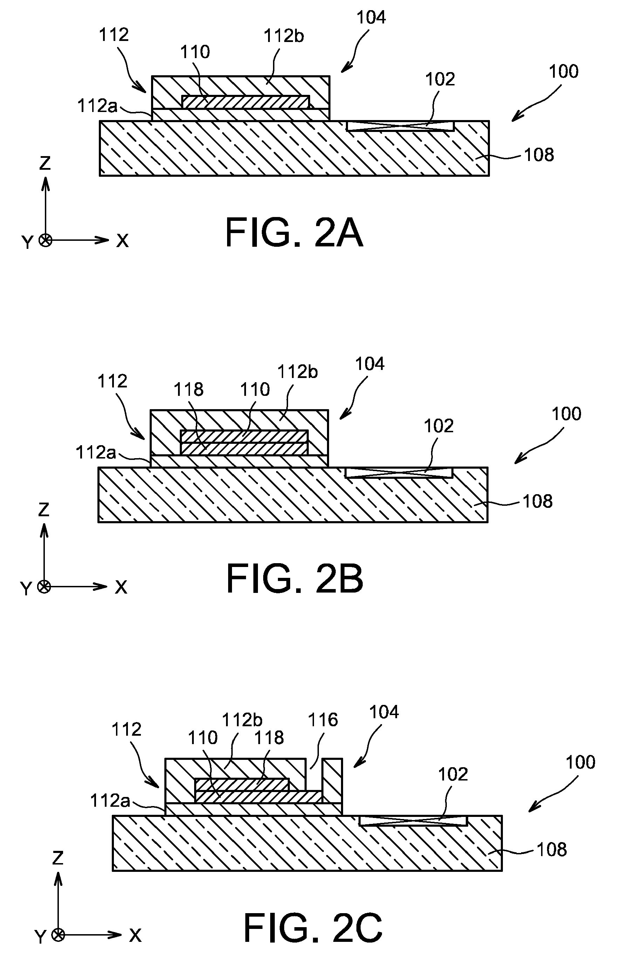

Dans un deuxième mode de réalisation représenté sur la figure 2A, la structure getter 104 peut comporter la portion de matériau getter perméable aux gaz 110 qui est complètement entourée par la couche de protection hermétique 112. Une telle configuration est par exemple obtenue en réalisant tout d'abord un dépôt d'une première partie 112a de la couche de protection hermétique 112, cette première partie 112a formant une portion de matériau (plane dans l'exemple décrit ici) disposée contre le substrat 108. La portion de matériau getter perméable aux gaz 110 est ensuite déposée sur la première partie 112a de la couche de protection hermétique 112. Des canaux sont éventuellement réalisés à travers la portion de matériau getter perméable aux gaz 110. Enfin, on réalise le dépôt d'une seconde partie 112b de la couche de protection hermétique 112 telle que cette couche de protection hermétique 112 entoure complètement et protège hermétiquement la portion de matériau getter perméable aux gaz 110. Toutes ces étapes seront avantageusement réalisées dans un même cycle de vide ou sous une même atmosphère.

Bien que non représenté, et comme précédemment décrit en liaison avec la figure 1B, la structure getter 104 et le microcomposant 102 sont encapsulés au sein de la cavité 106 formée par scellement du capot 114 au substrat 108. Une ou plusieurs ouvertures 116 sont ensuite réalisées à travers la couche de protection hermétique 112. Une telle variante est avantageusement réalisée lorsque le substrat 108 n'offre pas une herméticité suffisante pour protéger hermétiquement la portion de matériau getter perméable aux gaz 110.

Un troisième mode de réalisation est représenté sur la figure 2B. Par rapport au deuxième mode de réalisation précédemment décrit en liaison avec la figure 2A, la portion de matériau getter perméable aux gaz 110 recouvre une autre portion de matériau getter 118. La couche de protection hermétique 112 entoure donc complètement la portion de matériau getter perméable aux gaz 110 ainsi que l'autre portion de matériau getter 118. La portion de matériau getter 118 a par exemple une épaisseur comprise entre environ 100 nm et 10 µm. Compte tenu de la perméabilité de la portion de matériau getter 110, l'ensemble de la face, appelée face avant, de l'autre portion de matériau getter 118 se trouvant contre la portion de matériau getter perméable aux gaz 110 peut réaliser une absorption et/ou un adsorption gazeuse à travers les porosités et/ou les canaux traversant la portion de matériau getter perméable aux gaz 110, la ou les ouvertures localisées réalisées à travers la couche de protection 112 débouchant sur la portion de matériau getter perméable aux gaz 110.

Dans l'exemple décrit ici, la structure getter est par exemple obtenue en réalisant, sur la face du substrat 108 sur laquelle le microcomposant 102 est disposé, les portions de la première partie 112a de la couche de protection hermétique 112, qui ne sont alors pas recouvertes par le matériau getter 110. Sur cette première partie 112a, un dépôt du matériau getter destiné à former la portion 118 est ensuite réalisé et structuré (par exemple une gravure), afin de ne conserver que la portion de matériau getter 118 dont les dimensions correspondent aux dimensions souhaitées, ici équivalentes à celles de la portion de matériau getter perméable aux gaz 110 à réaliser. La portion de matériau getter perméable aux gaz 110 est ensuite réalisée sur la portion de matériau getter 118, l'ensemble étant ensuite encapsulé par la seconde partie 112b de la couche de protection hermétique 112.

En variante, la portion de matériau getter 118 peut être réalisée en une seule étape en déposant le matériau getter à travers un pochoir, formant ainsi directement la portion de matériau getter 118 aux dimensions souhaitées. Dans un mode de réalisation avantageux, les portions de matériau getter 118 et 110 peuvent être réalisées toutes les deux par deux dépôts successifs à travers un même pochoir, éventuellement au cours d'un même cycle de vide, c'est-à-dire sans remise à l'air entre ces deux dépôts. La deuxième partie 112b de la couche de protection hermétique 112 pourra également être réalisée par un dépôt mis en oeuvre successivement à la réalisation de la portion de matériau getter 110, au cours d'un même cycle de vide.

Selon une autre variante représentée sur la figure 2C, les portions de matériau getter 118 et 110 sont inversées dans l'empilement. Comme précédemment décrit en liaison avec la figure 1B, la structure getter 104 (formée successivement par la portion de matériau getter perméable aux gaz 110, la portion de matériau getter 118 et la couche de protection hermétique 112) et le microcomposant 102 peuvent être encapsulés au sein de la cavité 106 formée par scellement du capot 114 au substrat 108. Une ou plusieurs ouvertures 116 sont ensuite réalisées à travers la couche de protection hermétique 112, par exemple par impact laser. Dans ce mode de réalisation, la portion de matériau getter 110 perméable aux gaz est disposée sous la portion de matériau getter 118 et permet donc d'avoir accès à la face arrière de la portion 118. La portion 110 comporte des dimensions supérieures à celles de la portion 118 pour que l'ouverture 116 débouche directement sur cette portion 110. Le matériau getter de la portion 110 réalise donc une absorption et/ou une adsorption gazeuse à travers la ou les ouvertures 116, et le matériau getter de l'autre portion 118 réalise une absorption et/ou une adsorption gazeuse à travers la ou les ouvertures 116 et à travers les porosités et/ou les canaux de la portion getter 110 perméable aux gaz. Une telle configuration a pour avantage que toute la surface du matériau getter 118 (face arrière dans le cas de la figure 2C) se trouvant du côté de la portion de matériau getter perméable aux gaz 110 peut réaliser une absorption et/ou une adsorption gazeuse, même si une seule ouverture 116 de faibles dimensions est réalisée à travers la couche de protection hermétique 112.

Ainsi, on obtient une structure getter comprenant au moins deux matériaux getter différents pouvant présenter des propriétés d'absorption et/ou d'adsorption gazeuse différentes.

En variante, il est possible que la portion de matériau getter perméable aux gaz 110 entoure en partie ou complètement l'autre portion de matériau getter 118, et peut donc recouvrir les faces latérales et/ou la face arrière (celle se trouvant du côté du substrat 108) de la portion de matériau getter 118.

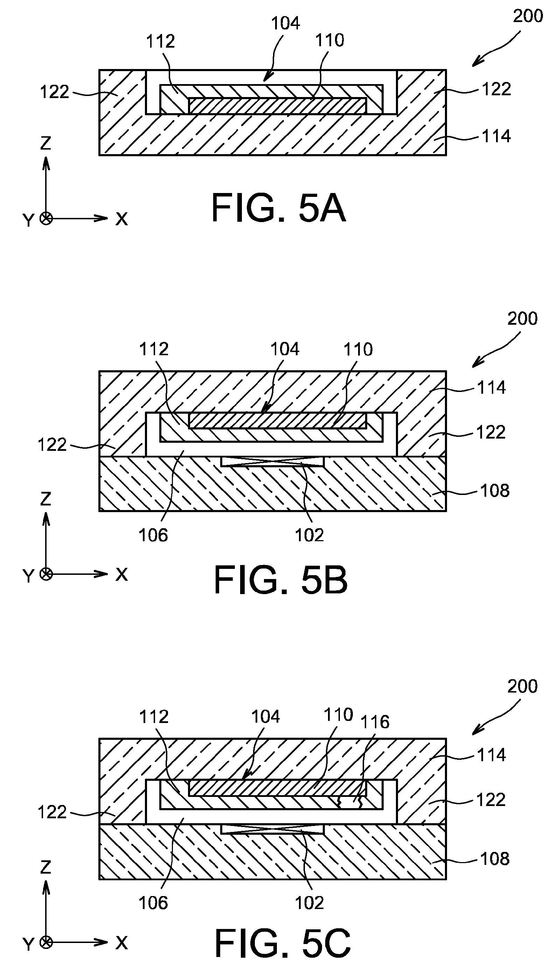

La figure 5A représente un dispositif 200 selon un quatrième mode de réalisation comportant la structure getter 104 similaire à celle précédemment décrite en liaison avec la figure 1. La structure getter 104 comporte la portion de matériau getter perméable aux gaz 110 recouverte par la couche de protection hermétique 112. Dans ce quatrième mode de réalisation, la structure getter 104 est réalisée sur le capot 114 qui sert de support à la portion de matériau getter perméable aux gaz 110 et à la couche de protection 112. Le capot 114 comporte des portions latérales 122 destinées à former des parois latérales de la cavité 106 dans laquelle la structure getter 104 sera encapsulée avec le microcomposant 102.

Le capot 114 est ensuite assemblé au substrat 108 sur lequel est réalisé le microcomposant 102, par exemple de type MEMS et/ou NEMS, formant ainsi le dispositif 200 (figure 5B). Le microcomposant 102 se retrouve donc encapsulé dans la cavité 106 formée entre le capot 114 et le substrat 108 et dans laquelle est également encapsulée la structure getter 104. Les parois latérales de la cavité 106 correspondent aux portions latérales 122 du capot 114. L'assemblage des portions latérales 122 au substrat 108 est réalisé par un scellement fermant hermétiquement la cavité 106, obtenu par exemple par collage moléculaire ou toute autre technique de scellement adaptée telle qu'un scellement anodique ou eutectique.

Les différentes étapes technologiques réalisées ensuite sur le dispositif 200 n'ont donc pas d'impact sur le matériau getter perméable aux gaz 110 tant que celui-ci est protégé par la couche de protection hermétique 112.

De plus, les capacités de pompage du matériau getter perméable aux gaz 110 sont préservées tant que celui-ci est confiné hermétiquement entre la couche de protection 112 et le capot 114.

Lorsque l'on souhaite « activer » la fonction d'absorption / adsorption gazeuse du matériau getter, on réalise l'ouverture 116 à travers la couche de protection hermétique 112 afin de former un accès à la portion de matériau getter perméable aux gaz 110 (figure 5C). Cette ouverture 116 est par exemple réalisée par impact laser à travers le substrat 108 (par exemple à base d'un matériau transparent au laser utilisé).

Si cet impact laser provoque des scories (déchets solides), il est possible de réaliser cette ouverture 116 dans une portion de la couche de la protection 112 éloignée du microcomposant 102 afin de réduire ou supprimer la pollution de ces scories qui peuvent potentiellement altérer le fonctionnement du microcomposant 102.

Grâce à cette ouverture 116, le matériau getter perméable aux gaz 110 peut remplir sa fonction d'absorption et/ou d'adsorption gazeuse à travers l'ouverture 116. On peut ainsi réaliser par exemple un environnement sous pression réduite dans la cavité 106, autour du microcomposant 102.

Dans une variante de réalisation du dispositif 200, la structure getter 104 peut correspondre à l'une de celles précédemment décrites en liaison avec les figures 2A et 2B, c'est-à-dire pouvant comporter une autre portion de matériau getter 118 et/ou être complètement entourée par la couche de protection hermétique 112.

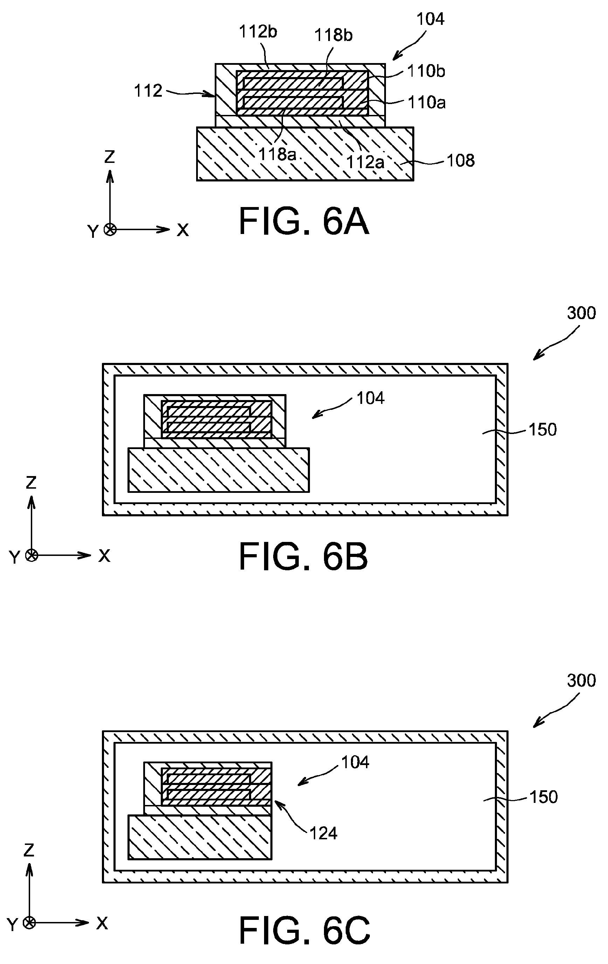

Les figures 6A à 6C représentent les étapes de réalisation d'un dispositif 300 selon un cinquième mode de réalisation.

Comme représenté sur la figure 6A, la structure getter 104 comporte ici un empilement de plusieurs portions de matériau getter (deux sur l'exemple de la figure 6) 118a et 118b disposées sur une partie du substrat 108. Les portions de matériau getter 118a, 118b sont ici entièrement entourées par des portions de matériau getter perméable aux gaz 110a, 110b. L'ensemble de cet empilement est protégé par la couche de protection hermétique 112 qui entoure complètement les portions de matériau getter perméable aux gaz 110a, 110b, et donc recouvre intégralement les autres portions de matériau getter 118a, 118b. Dans ce cinquième mode de réalisation, toutes les faces des autres portions de matériau getter 118a, 118b sont en contact avec le matériau getter perméable aux gaz des portions 110a, 110b. On obtient ainsi une structure getter 104 pouvant être utilisée de manière autonome, et pouvant par exemple être disposée dans une cavité 150 d'un dispositif 300, par exemple un tube écran (voir figure 6B). La perméabilité aux gaz des portions de matériau getter 110a, 110b est obtenue grâce à des canaux formés à travers les portions 110a, 110b et/ou grâce à au fait que le matériau getter des portions 110a, 110b est poreux.

Afin d'activer la fonction de pompage gazeux de la structure getter 104, on créé une ouverture locale de la structure getter 104 afin de mettre à nu une partie des portions de matériau getter perméable aux gaz 110a, 110b (figure 6C). Cette ouverture est par exemple obtenue en cassant, par exemple par un choc de la structure getter 104 contre une paroi de la cavité 150 ou par un tir laser, une partie de la structure getter 104. On obtient ainsi une ouverture locale 124 formée à travers la couche de protection hermétique 112 et formant un accès aux portions de matériau getter perméable aux gaz 110a, 110b et aux autres portions de matériau getter 118a, 118b via les porosités et/ou canaux des portions de matériau getter perméables aux gaz 110a, 110b. Il est possible de faciliter la réalisation de l'ouverture locale 124 de la structure getter 104 en réalisant au préalable une amorce mécanique au sein de la structure getter 104. Cette ouverture 124 peut être réalisée en conservant intacte les portions de matériau getter 118a, 118b.

Ainsi, par l'intermédiaire de l'ouverture 124 réalisée à travers la couche de protection 112 et qui débouche sur les portions de matériau getter perméables aux gaz 110a, 110b, les portions de matériau getter perméables aux gaz 110a, 110b et les autres portions de matériau getter 118a, 118b peuvent réaliser une absorption et/ou une adsorption gazeuse depuis l'ensemble de leurs faces (faces avant, arrière et latérales).

La structure getter 104 représentée sur la figure 6A peut être obtenue en réalisant tout d'abord une première partie 112a de la couche de protection hermétique 112, par exemple par dépôt, cette partie formant une portion de couche plane disposée contre le substrat 108. Une première partie (également sous la forme d'une portion plane) de la première portion de matériau getter perméable aux gaz 110a est ensuite formée sur la première partie 112a de la couche de protection hermétique 112. La première autre portion de matériau getter 118a est ensuite déposée sur la première partie de la première portion de matériau getter perméable aux gaz 110a. Une seconde partie de la première portion de matériau getter perméable aux gaz 110a est ensuite déposée sur la première autre portion de matériau getter 118a telle que la première autre portion de matériau getter 118a soit complètement entourée par la première portion de matériau getter perméable aux gaz 110a. La deuxième autre portion de matériau getter 118b est ensuite déposée sur la première portion de matériau getter perméable aux gaz 110a, en utilisant par exemple le même pochoir que celui utilisé pour le dépôt de la première autre portion de matériau getter 118a. La deuxième portion de matériau getter perméable aux gaz 110b est ensuite déposée en recouvrant complètement la deuxième autre portion de matériau getter 118b. Enfin, on réalise le dépôt d'une seconde partie 112b de la couche de protection hermétique 112 telle que cette couche de protection hermétique 112 entoure et protège hermétiquement les portions de matériau getter 110a, 110b, 118a et 118b. Toutes ces étapes seront avantageusement réalisées dans un même cycle de vide.

Dans tous les modes de réalisation, le matériau getter est généralement rendu actif après son dépôt (lorsque les différents dépôts n'ont pas été réalisés au cours du même cycle de vide) et par exemple après son encapsulation dans la couche de protection hermétique 112, par une étape d'activation thermique.

Par exemple, dans le cas d'un matériau getter composé de titane, une telle activation thermique peut être réalisée à une température par exemple comprise entre environ 350°C et 450°C.

Dans tous les modes de réalisation précédemment décrits, la ou les portions de matériau getter sont planes du fait que les différents supports sur lesquels la ou les portions de matériau getter sont réalisées présentent une surface sensiblement plane.

Toutefois, il est possible que la portion de matériau getter ne soit pas plane mais qu'elle présente des reliefs (creux et/ou bosses ou saillies).

Dans tous les modes de réalisation précédemment décrits, il est possible que plusieurs portions de matériau getter perméables aux gaz soient entourées ou recouvertes par la couche de protection hermétique. Dans ce cas, les portions de matériau getter perméables aux gaz peuvent être disposées les unes à côté des autres et/ou les unes au-dessus des autres, et être éventuellement espacées les unes des autres.

## Revendications

1. Procédé de réalisation d'un dispositif (100, 200, 300) comportant au moins les étapes de :
- réalisation d'une structure getter (104) comportant au moins une portion de matériau getter perméable aux gaz (110, 110a, 110b) recouverte par au moins une couche de protection (112, 112a, 112b) hermétique aux gaz, puis
- encapsulation hermétique de la structure getter (104) dans une cavité (106, 150), puis
- réalisation d'au moins une ouverture localisée (116, 124) traversant la couche de protection (112, 112a, 112b) et formant un accès à la portion de matériau getter perméable aux gaz (110, 110a, 110b).

2. Procédé selon la revendication 1, dans lequel la portion de matériau getter perméable aux gaz (110, 110a, 110b) comporte un ou plusieurs canaux (120a, 120b) réalisés dans ladite portion de matériau getter perméable aux gaz (110, 110a, 110b).

3. Procédé selon l'une des revendications précédentes, dans lequel la portion de matériau getter perméable aux gaz (110, 110a, 110b) est composée d'au moins un matériau poreux.

4. Procédé selon l'une des revendications précédentes, dans lequel la couche de protection (112, 112a, 112b) a une épaisseur supérieure à environ 100 nm.

5. Procédé selon l'une des revendications précédentes, dans lequel la cavité (106) est formée entre un substrat (108) et un capot (114), la structure getter étant solidaire du substrat (108) et/ou du capot (114).

6. Procédé selon l'une des revendications précédentes, comportant en outre au moins un microcomposant (102) encapsulé hermétiquement dans la cavité (106).

7. Procédé selon l'une des revendications précédentes, dans lequel l'ouverture localisée (116, 124) est réalisée par au moins une fusion localisée de la couche de protection (112, 112a, 112b) et/ou en cassant une partie de la structure getter (104).

8. Procédé selon l'une des revendications précédentes, dans lequel la portion de matériau getter perméable aux gaz (110, 110a, 110b) est réalisée par au moins un dépôt de matériau getter sur un support (108, 114), la couche de protection (112, 112b) étant déposée sur la portion de matériau getter perméable aux gaz (110, 110a, 110b) et sur une partie du support (108, 114).

9. Procédé selon l'une des revendications 1 à 7, comportant en outre, avant la réalisation de la portion de matériau getter perméable aux gaz (110, 110a, 110b), la réalisation d'une première partie (112a) de la couche de protection (112) contre un support (108, 114), la portion de matériau getter perméable aux gaz (110, 110a, 110b) étant réalisée ensuite sur cette première partie (112a) de la couche de protection (112), et comportant en outre la réalisation d'une seconde partie (112b) de la couche de protection (112) recouvrant la portion de matériau getter perméable aux gaz (110, 110a, 110b) et reposant sur la première partie (112a) de la couche de protection (112).

10. Procédé selon l'une des revendications précédentes, comportant en outre, entre une étape de réalisation de la portion de matériau getter perméable aux gaz (110, 110a, 110b) et une étape de réalisation de la couche de protection (112, 112a, 112b), une étape de réalisation d'au moins une autre portion de matériau getter (118, 118a, 118b) distincte de la portion de matériau getter perméable aux gaz (110, 110a, 110b) et disposée contre la portion de matériau getter perméable aux gaz (110, 110a, 110b) telle que ladite autre portion de matériau getter (118, 118a, 118b) soit apte à réaliser une absorption et/ou une adsorption gazeuse à travers au moins la portion de matériau getter perméable aux gaz (110, 110a, 110b), la couche de protection (112, 112a, 112b) recouvrant ladite autre portion de matériau getter (118, 118a, 118b).

11. Procédé selon l'une des revendications 1 à 9, comportant en outre, avant une étape de réalisation de la portion de matériau getter perméable aux gaz (110, 110a, 110b), une étape de réalisation d'au moins une autre portion de matériau getter (118, 118a, 118b) distincte de la portion de matériau getter perméable aux gaz (110, 110a, 110b), la portion de matériau getter perméable aux gaz (110, 110a, 110b) étant réalisée sur ladite autre portion de matériau getter (118, 118a, 118b) telle que ladite autre portion de matériau getter (118, 118a, 118b) soit apte à réaliser une absorption et/ou une adsorption gazeuse à travers au moins la portion de matériau getter perméable aux gaz (110, 110a, 110b), la couche de protection (112, 112a, 112b) recouvrant ladite portion de matériau getter perméable aux gaz (110, 110a, 110b).

12. Procédé selon la revendication 10, dans lequel la portion de matériau getter perméable aux gaz (110, 110a, 110b) est réalisée telle qu'elle entoure tout ou partie de ladite autre portion de matériau getter (118, 118a, 118b).

13. Procédé selon l'une des revendications précédentes, comportant la réalisation d'un empilement de plusieurs portions de matériau getter perméables aux gaz (110a, 110b) et de plusieurs autres portions de matériau getter (118a, 118b) tel qu'au moins une face de chacune desdites autres portions de matériau getter (118a, 118b) soit disposée contre au moins une des portions de matériau getter perméables aux gaz (110a, 110b), chacune desdites autres portions de matériau getter (118a, 118b) étant apte à réaliser une absorption et/ou une adsorption gazeuse par ladite face à travers ladite au moins une des portions de matériau getter perméables aux gaz (110a, 110b), la couche de protection (112, 112a, 112b) recouvrant ledit empilement.

14. Procédé selon l'une des revendications précédentes, dans laquelle la couche de protection (112, 112a, 112b) encapsule entièrement la ou les portions de matériau getter perméables aux gaz (110, 110a, 110b) et, lorsque la structure getter (104) comporte au moins une autre portion de matériau getter (118, 118a, 118b), la couche de protection (112, 112a, 112b) encapsule entièrement ladite ou lesdites autres portions de matériau getter (118, 118a, 118b), l'ouverture localisée (116, 124) formant un accès au moins à la ou aux portions de matériau getter perméables aux gaz (110, 110a, 110b).

15. Procédé selon l'une des revendications précédentes, comportant en outre la réalisation d'un microcomposant (102) et l'encapsulation hermétique du microcomposant (102) dans la cavité (106).

## Patentansprüche

1. Verfahren zur Herstellung einer Vorrichtung (100,200,300) aufweisend mindestens die folgenden Schritte:
- Herstellung einer Getter-Struktur (104) die mindestens einen gasdurchlässigen Teil des Gettermaterials (110, 110a, 110b) aufweist und die mit mindestens einer gasdichten Schutzschicht (112, 112a, 112b) bedeckt ist, dann
- hermetische Verkapselung der Getter-Struktur (104) in einem Hohlraum (106, 150), dann
- Herstellung mindestens einer lokalisierten Öffnung (116, 124), die sich durch die Schutzschicht (112, 112a, 112b) erstreckt und die einen Zugang zu dem gasdurchlässigen Teil des Gettermaterials (110, 110a, 110b) bildet.

2. Verfahren nach Anspruch 1, worin der gasdurchlässige Teil des Gettermaterials (110, 110a, 110b) einen oder mehrere in dem gasdurchlässigen Teil des Gettermaterials (110, 110a, 110b) vorliegende Kanäle (120a, 120b) aufweist.

3. Verfahren nach einem der vorherigen Ansprüche, worin der gasdurchlässigen Teil des Gettermaterials (110, 110a, 110b) aus mindestens einem porösen Material besteht.

4. Verfahren nach einem der vorherigen Ansprüche, worin die Schutzschicht (112, 112a, 112b) eine Dicke größer als etwa 100 nm aufweist.

5. Verfahren nach einem der vorherigen Ansprüche, worin der Hohlraum (106) zwischen einem Substrat (108) und einer Abdeckung (114) gebildet ist, wobei die Getter-Struktur mit dem Substrat (108) und /oder der Abdeckung (114) verbunden ist.

6. Verfahren nach einem der vorherigen Ansprüche, weiterhin aufweisend mindestens eine Mikrokomponente (102), die hermetisch in dem Hohlraum (106) verkapselt ist.

7. Verfahren nach einem der vorherigen Ansprüche, worin die lokalisierte Öffnung (116, 124) durch mindestens ein lokalisiertes Verschmelzen der Schutzschicht (112, 112a, 112b) und /oder beim Aufbrechen eines Abschnitts der Getter-Struktur (104) gebildet wird.

8. Verfahren nach einem der vorherigen Ansprüche, worin der gasdurchlässige Teil des Gettermaterials (110, 110a, 110b) durch mindestens eine Ablagerung von Gettermaterial auf einen Träger (108, 114) gebildet ist, wobei die Schutzschicht (112, 112b) auf dem gasdurchlässigen Teil des Gettermaterials (110, 110a, 110b) und auf einem Abschnitt des Trägers (108, 114) abgeschieden wird.

9. Verfahren nach einem der Ansprüche 1 bis 7, weiterhin aufweisend, vor der Herstellung des gasdurchlässigen Teils des Gettermaterials (110, 110a, 110b) die Herstellung eines ersten Abschnitts (112a) der Schutzschicht (112) auf einem Träger (108, 114), wobei danach der gasdurchlässige Teil des Gettermaterials (110, 110a, 110b) auf diesem ersten Abschnitt (112a) der Schutzschicht (112) gebildet wird und weiterhin aufweisend die Herstellung eines zweiten Abschnitts (112b) der Schutzschicht (112), der den gasdurchlässigen Teil des Gettermaterials (110, 110a, 110b) bedeckt und sich auf dem ersten Abschnitt (112a) der Schutzschicht (112) befindet.

10. Verfahren nach einem der vorherigen Ansprüche, weiterhin aufweisend einen Schritt der Herstellung von mindestens einem weiteren Teil des Gettermaterials (118, 118a, 118b), der von dem gasdurchlässigen Teil des Gettermaterials (110, 110a, 110b) verschieden ist und auf dem gasdurchlässigen Teil des Gettermaterials (110, 110a, 110b) angeordnet ist, zwischen einem Schritt der Herstellung des gasdurchlässigen Teils des Gettermaterials (110, 110a, 110b) und einem Schritt der Herstellung der Schutzschicht (112, 112a, 112b), wobei der weitere Teil des Gettermaterials (118, 118a, 118b) geeignet ist, um eine Absorption und/oder eine Adsorption von Gas durch mindestens den gasdurchlässigen Teil des Gettermaterials (110, 110a, 110b) zu bewirken, wobei die Schutzschicht (112, 112a, 112b) den weiteren Teil des Gettermaterials (118, 118a, 118b) bedeckt.

11. Verfahren nach einem der Ansprüche 1 bis 9, weiterhin aufweisend vor dem Schritt der Herstellung des gasdurchlässigen Teils des Gettermaterials (110, 110a, 110b) einen Schritt der Herstellung von mindestens einem weiteren Teil des Gettermaterials (118, 118a, 118b), der von dem gasdurchlässigen Teil des Gettermaterials (110, 110a, 110b) verschieden ist, wobei der gasdurchlässige Teil des Gettermaterials (110, 110a, 110b) auf dem weiteren Teil des Gettermaterials (118, 118a, 118b) geblidet wird, wobei der weitere Teil des Gettermaterials (118, 118a, 118b) geeignet ist, um eine Absorption und/oder eine Adsorption von Gas durch mindestens den gasdurchlässigen Teil des Gettermaterials (110, 110a, 110b) zu bewirken, wobei die Schutzschicht (112, 112a, 112b) den gasdurchlässigen Teil des Gettermaterials (110, 110a, 110b) bedeckt.

12. Verfahren nach Anspruch 10, worin der gasdurchlässige Teil des Gettermaterials (110, 110a, 110b) so ausgebildet ist, dass er den weiteren Teil des Gettermaterials (118, 118a, 118b) ganz oder teilweise umschließt.

13. Verfahren nach einem der vorherigen Ansprüche, aufweisend die Herstellung eines Stapels aus mehreren gasdurchlässigen Teilen des Gettermaterials (110a, 110b) und aus mehreren weiteren Teilen des Gettermaterials (118a, 118b), so dass mindestens eine Seite jedes weiteren Teils des Gettermaterials (118a, 118b) auf mindestens einem der gasdurchlässigen Teile des Gettermaterials (110a, 110b) angeordnet ist, wobei jeder der weiteren Teile des Gettermaterials (118a, 118b) geeignet ist, um eine Absorption und/oder eine Adsorption von Gas mit der jeniger Seite durch den mindestens einen der gasdurchlässigen Teile des Gettermaterials (110a, 110b) zu bewirken, wobei die Schutzschicht (112, 112a, 112b) den Stapel bedeckt.

14. Verfahren nach einem der vorherigen Ansprüche, worin die Schutzschicht (112, 112a, 112b) den oder die gasdurchlässigen Teil(e) des Gettermaterials (110, 110a, 110b) vollständig einschließt und, sofern die Getter-Struktur (104) mindestens einen weiteren Teil des Gettermaterials (118, 118a, 118b) aufweist, die Schutzschicht (112, 112a, 112b) vollständig den Teil oder die weiteren Teilen des Gettermaterials (118, 118a, 118b) einschließt, wobei die lokalisierte Öffnung (116, 124) einen Zugang zu mindestens dem gasdurchlässigen Teil oder den gasdurchlässigen Teilen des Gettermaterials (110, 110a, 110b) bildet.

15. Verfahren nach einem der vorherigen Ansprüche, weiterhin aufweisend die Herstellung einer Mikrokomponente (102) und die hermetische Verkapselung der Mikrokomponente (102) in dem Hohlraum (106).

## Claims

1. Process for making a device (100, 200, 300) comprising at least the following steps:
- producing a getter structure (104) comprising at least one portion of getter material permeable to gas (110, 110a, 110b) covered by at least one protective layer (112, 112a, 112b) hermetic to gas, then
- hermetic encapsulation of the getter structure (104) in a cavity (106, 150), then
- production of at least one local opening (116, 124) passing through the protective layer (112, 112a, 112b) and forming an access to the portion of getter material permeable to gas (110, 110a, 110b).

2. Process according to claim 1, in which the portion of getter material permeable to gas (110, 110a, 110b) comprises one or several channels (120a, 120b) made in said portion of getter material permeable to gas (110, 110a, 110b).

3. Process according to one of previous claims, in which the portion of getter material permeable to gas (110, 110a, 110b) comprises at least one porous material.

4. Process according to one of previous claims, in which the thickness of the protective layer (112, 112a, 112b) is higher than around 100 nm.

5. Process according to one of previous claims, in which the cavity (106) is formed between a substrate (108) and a cover (114), the getter structure being fixed to the substrate (108) and/or to the cover (114).

6. Process according to one of previous claims, also comprising at least one microcomponent (102) hermetically encapsulated in the cavity (106).

7. Process according to one of previous claims, in which the local opening (116, 124) is made by at least one local melting of the protective layer (112, 112a, 112b) and/or by breaking a part of the getter structure (104).

8. Process according to one of previous claims, in which the portion of getter material permeable to gas (110, 110a, 110b) is made by at least one deposit of getter material on a support (108, 114), the protective layer (112, 112b) being deposited on the portion of getter material permeable to gas (110, 110a, 110b) and on a part of the support (108, 114).

9. Process according to one of claims 1 to 7, also comprising, before the production of the portion of getter material permeable to gas (110, 110a, 110b), the production of a first part (112a) of the protective layer (112) in contact with a support (108, 114), the portion of getter material permeable to gas (110, 110a, 110b) being made later on this first part (112a) of the protective layer (112), and also comprising production of a second part (112b) of the protective layer (112) covering the portion of getter material permeable to gas (110, 110a, 110b) and supported on the first part (112a) of the protective layer (112).

10. Process according to one of previous claims, also comprising, between a step in which the portion of getter material permeable to gas (110, 110a, 110b) is made and a step in which the protective layer (112, 112a, 112b) is made, a step of making at least one other portion of getter material (118, 118a, 118b) distinct from the portion of getter material permeable to gas (110, 110a, 110b) and arranged in contact with the portion of getter material permeable to gas (110, 110a, 110b) such that said other portion of getter material (118, 118a, 118b) is capable of doing gas absorption and/or gas adsorption through at least the portion of getter material permeable to gas (110, 110a, 110b), the protective layer (112, 112a, 112b) covering said other portion of getter material (118, 118a, 118b).

11. Process according to one of claims 1 to 9, also comprising, before a step in which the portion of getter material permeable to gas (110, 110a, 110b) is produced, a step of making at least one other portion of getter material (118, 118a, 118b) distinct from the portion of getter material permeable to gas (110, 110a, 110b), the portion of getter material permeable to gas (110, 110a, 110b) being made on said other portion of getter material (118, 118a, 118b) such that said other portion of getter material (118, 118a, 118b) is capable to do gas absorption and/or gas adsorption through at least the portion of getter material permeable to gas (110, 110a, 110b), the protective layer (112, 112a, 112b) covering said portion of getter material permeable to gas (110, 110a, 110b).

12. Process according to claim 10, in which the portion of material permeable to gas (110, 110a, 110b) is made such that it surrounds all or some of said other portion of getter material (118, 118a, 118b).

13. Process according to one of previous claims, comprising the production of a stack of several portions of getter material permeable to gas (110a, 110b) and several other portions of getter material (118a, 118b) such that at least one face of each of said other portions of getter material (118a, 118b) is arranged in contact with at least one of the portions of getter material permeable to gas (110a, 110b), each of said other portions of getter material (118a, 118b) being capable of gas absorption and/or gas adsorption through said face through said at least one of the portions of getter material permeable to gas (110a, 110b), the protective layer (112, 112a, 112b) covering said stack.

14. Process according to one of previous claims, in which the protective layer (112, 112a, 112b) entirely encapsulates the portion(s) of getter material permeable to gas (110, 110a, 110b), and when the getter structure (104) comprises at least one other portion of getter material (118, 118a, 118b), the protective layer (112, 112a, 112b) entirely encapsulates said other portion(s) of getter material (118, 118a, 118b), the local opening (116, 124) forming an access to at least the portion(s) of getter material permeable to gas (110, 110a, 110b).

15. Process according to one of previous claims, also comprising the production of a microcomponent (102) and a hermetic encapsulation of the microcomponent (102) in the cavity (106).
